# EUROPÄISCHE PATENTSCHRIFT

(11) **EP 2 043 209 B1**
(45) Veröffentlichungstag und Bekanntmachung des Hinweises auf die Patenterteilung: **26.10.2011**
(21) Anmeldenummer: 08015212.7
(22) Anmeldetag: 28.08.2008
(51) Int. Cl.: H01S 5/16, H01S 5/042, H01S 5/10, H01S 5/12

(54) **Kantenemittierender Halbleiterlaser mit einem Wellenleiter**
Edge emitting semiconductor laser with a waveguide
Laser semi-conducteur à émission latérale avec un guide d'onde

(30) Priorität: 28.09.2007 DE 102007046722; 07.12.2007 DE 102007058950
(43) Veröffentlichungstag der Anmeldung: 01.04.2009
(60) Teilanmeldung: 11161727.0
(73) Patentinhaber: OSRAM Opto Semiconductors GmbH, 93055 Regensburg (DE)
(72) Erfinder: Schmid, Wolfgang, Dr., 93053 Regensburg (DE)
(74) Vertreter: Epping - Hermann - Fischer

(56) Entgegenhaltungen:
- EP-A- 0 332 723
- JP-A- 2001 350 044
- US-A- 4 297 652
- US-A- 4 757 509

## Beschreibung

Die Erfindung betrifft einen kantenemittierenden Halbleiterlaser gemäß dem Oberbegriff des Patentanspruchs 1.

Diese Patentanmeldung beansprucht die Priorität der deutschen Patentanmeldungen 10 2007 046 722.4 und 10 2007 058 950.8.

Bei kantenemittierenden Halbleiterlasern treten an den Oberflächen der Seitenfacetten, die die Laserspiegel des kantenemittierenden Halbleiterlasers ausbilden, mit einer erhöhten Wahrscheinlichkeit nicht-strahlende Rekombinationen auf, das heißt Ladungsträger rekombinieren im Bereich der Seitenfacetten verstärkt unter der Erzeugung von Wärme. Die dadurch auftretende Ladungsträgerverarmung wird durch Absorption von Laserstrahlung ausgeglichen. Da die Wärmeerzeugung an der Seitenfacette stärker ist als im Inneren des Halbleiterkörpers, ist der Halbleiter hier wärmer, wodurch sich die Bandlücke des Halbleitermaterials vermindert. Dadurch werden nicht-strahlende Rekombinationen weiter begünstigt, was zu einer weiteren Erhöhung der Wärmeentwicklung führen kann. Bei vergleichsweise hohen Laserintensitäten kann ein instabiler Kreislauf entstehen, der bis zur Aufschmelzung der Seitenfacette führen kann. Dieser mögliche Zerstörungsmechanismus ist insbesondere für die aktive Schicht kritisch, da die benachbarten Schichten in der Regel eine größere Bandlücke aufweisen und damit für die Laserstrahlung im Wesentlichen transparent sind.

Aus der Druckschrift EP 0 416 190 A1 ist bekannt, die Seitenfacetten des Halbleiterlasers mit einer Passivierungsschicht zu versehen.

In der Druckschrift US 6,323,052 B1 wird beschrieben, die Seitenfacetten des Halbleiterlasers mit einem Sputterprozess zu behandeln, um dort Oxide zu beseitigen, die zu nichtstrahlenden Rekombinationen führen könnten.

In der Druckschrift US 5,171,707 wird ein Verfahren beschrieben, mit dem im Bereich der Seitenfacetten eines kantenemittierenden Halbleiterlasers durch diffusionsinduzierte Durchmischung transparente Bereiche erzeugt werden, die die von der aktiven Schicht erzeugte Strahlung nicht absorbieren. Ein ähnliches Verfahren ist auch aus der Druckschrift WO 96/11503 A2 bekannt.

Die Druckschrift EP 0 332 723 A1 beschreibt einen kantenemittierenden Halbleiterlaser mit einem aktiven und einem passiven Wellenleiter.

In der Druckschrift US 4,297,652 wird ein Halbleiterlaser beschrieben, bei dem die aktive Schicht und deren Kontaktstruktur eine periodische Struktur aufweisen.

In der Druckschrift JP 2001 350 044 A wird ein Wellenleiterbauelement mit mehreren nebeneinander angeordneten Wellenleitern beschrieben.

Der Erfindung liegt die Aufgabe zugrunde, einen verbesserten kantenemittierenden Halbleiterlaser anzugeben, bei dem die Wärmeerzeugung in der aktiven Schicht durch nicht-strahlende Rekombinationen an der Seitenfacette des Halbleiterlasers vermindert ist.

Diese Aufgabe wird durch einen kantenemittierenden Halbleiterlaser mit den Merkmalen des Patentanspruchs 1 gelöst. Vorteilhafte Ausgestaltungen und Weiterbildungen der Erfindung sind Gegenstand der abhängigen Ansprüche.

Bei einem kantenemittierenden Halbleiterlaser mit einer Laserstrahlung erzeugenden aktiven Schicht, die in eine erste Wellenleiterschicht eingebettet ist, wobei die erste Wellenleiterschicht zwischen einer ersten Mantelschicht und einer zweiten Mantelschicht angeordnet ist und in lateraler Richtung an Seitenfacetten des Halbleiterlasers angrenzt, grenzt an die zweite Mantelschicht eine zweite Wellenleiterschicht an, in die keine aktive Schicht eingebettet ist, wobei die zweite Wellenleiterschicht zumindest in Teilbereichen optisch an die erste Wellenleiterschicht gekoppelt ist. An einer von der ersten Wellenleiterschicht abgewandten Seite der zweiten Wellenleiterschicht ist eine dritte Mantelschicht angeordnet.

Der kantenemittierende Halbleiterlaser enthält also einen aktiven Wellenleiter, der aus der ersten Wellenleiterschicht mit der darin eingebetteten aktiven Schicht gebildet wird, und einen optisch an den ersten Wellenleiter gekoppelten passiven Wellenleiter, der durch die zweite Wellenleiterschicht gebildet wird, die keine aktive Schicht enthält. Darunter, dass die zweite Wellenleiterschicht zumindest in Teilbereichen optisch an die erste Wellenleiterschicht gekoppelt ist, wird im Rahmen dieser Anmeldung verstanden, dass die in der aktiven Schicht erzeugte Laserstrahlung in diesen Teilbereichen zumindest teilweise aus dem ersten Wellenleiter in den zweiten Wellenleiter überkoppeln kann. Die in der aktiven Schicht des kantenemittierenden Halbleiterlasers erzeugte Laserstrahlung breitet sich daher nicht nur in der ersten Wellenleiterschicht, in die die aktive Schicht eingebettet ist, aus, sondern zumindest in Teilbereichen des Halbleiterlasers auch in der zweiten Wellenleiterschicht.

Bevorzugt sind die erste Wellenleiterschicht und die zweite Wellenleiterschicht derart optisch aneinander gekoppelt, dass sich an den Seitenfacetten des Halbleiterlasers zumindest ein Teil der in der aktiven Schicht erzeugten Laserstrahlung in der zweiten Wellenleiterschicht ausbreitet. Auf diese Weise wird vorteilhaft erreicht, dass die Intensität der Laserstrahlung in der aktiven Schicht an den Seitenfacetten geringer ist als bei einem herkömmlichen kantenemittierenden Halbleiterlaser, der keinen optisch an den ersten Wellenleiter gekoppelten zweiten Wellenleiter enthält. Nicht-strahlende Rekombinationen von Ladungsträgern und die damit verbundene Wärmeentwicklung an der Seitenfacette des Halbleiterlasers im Bereich der aktiven Schicht werden auf diese Weise vermindert. Die zweite Wellenleiterschicht weist vorzugsweise eine größere elektronische Bandlücke auf als die aktive Schicht, so dass die zweite Wellenleiterschicht für die Laserstrahlung im Wesentlichen transparent ist und somit nicht die in der Einleitung beschriebene Problematik der Absorption von Laserstrahlung aufgrund einer Ladungsträgerverarmung an der Seitenfacette aufweist. Das Risiko einer Schädigung des Bauelements durch eine hohe Intensität der Laserstrahlung an der Seitenfacette ist also im Bereich der zweiten Wellenleiterschicht geringer als im Bereich der ersten Wellenleiterschicht, die die aktive Schicht enthält.

Bevorzugt ist die zweite Wellenleiterschicht derart an die erste Wellenleiterschicht optisch gekoppelt, dass die sich in der ersten Wellenleiterschicht ausbreitende Laserstrahlung an den Seitenfacetten des Halbleiterlasers ein Intensitätsminimum aufweist.

Die Erfindung macht sich die Erkenntnis zu Nutze, dass elektromagnetische Strahlung, die sich in benachbarten Wellenleiterschichten ausbreitet, zumindest teilweise von dem einen Wellenleiter in den anderen Wellenleiter überkoppeln kann. Es ist sogar eine vollständige Überkopplung der Strahlung möglich, falls sich die elektromagnetischen Wellen in beiden Wellenleitern gleich schnell ausbreiten.

Die Grundlagen der optischen Kopplung zweier Wellenleiter sind an sich aus der integrierten Optoelektronik bekannt. Die Stärke der Kopplung zweier Wellenleiter wird durch den Koppelfaktor κ = π/2L_{c} beschrieben, wobei L_{c} die Transferlänge ist, die die Länge der Kopplungsstrecke angibt, in der die maximal mögliche Überkopplung der Strahlung aus dem ersten Wellenleiter in den zweiten Wellenleiter erfolgt. Für den Fall einer vollständigen Überkopplung gibt die Transferlänge also die Länge der Kopplungsstrecke an, in der die Strahlung vollständig aus dem ersten Wellenleiter in den zweiten Wellenleiter überkoppelt. Eine vollständige Überkopplung findet statt, wenn die Phasenabweichung δ = Δn π/λ = 0 wird, wobei λ die Wellenlänge der Strahlung und Δn die Brechungsindexdifferenz zwischen den Wellenleitern ist. Das örtliche Verhalten der Wellen in gekoppelten Wellenleitern verhält sich ähnlich wie das zeitliche Verhalten von Schwingungen bei einem gekoppelten Pendel. Eine Phasenabweichung δ ≠ 0 entspricht dem Fall einer unterschiedlichen Eigenfrequenz der einzelnen Pendel, in dem kein vollständiger Energietransfer möglich wäre.

Im vorliegenden Fall der zumindest teilweise optisch gekoppelten Wellenleiterschichten kann die Phasenabweichung δ und damit die Stärke der optischen Kopplung insbesondere durch die Wahl der Dicke und des Brechungsindex der zwischen den Wellenleiterschichten angeordneten zweiten Mantelschicht sowie durch die effektiven Brechungsindizes der beiden Wellenleiterschichten eingestellt werden. Beispielsweise kann die zweite Mantelschicht in lateraler Richtung eine konstante Dicke und einen konstanten Brechungsindex aufweisen, wobei die Stärke der Kopplung zwischen der ersten Wellenleiterschicht und der zweiten Wellenleiterschicht durch eine lokale Variation des effektiven Brechungsindex einer der beiden Wellenleiterschichten räumlich verändert wird.

Unter dem effektiven Brechungsindex n_{eff} einer Wellenleiterschicht wird hier und im Folgenden der Brechungsindex verstanden, der das Verhältnis der Wellenzahl k_{eff} bei der Ausbreitung in der Wellenleiterschicht im Vergleich zum Vakuum angibt, es ist also k_{eff}= n_{eff} 2π/λ. Der effektive Brechungsindex kann von dem Brechungsindex des Halbleitermaterials der Wellenleiterschicht abweichen, weil die Laserstrahlung bei der Ausbreitung in der Wellenleiterschicht teilweise in die benachbarten Mantelschichten eindringen kann.

Durch die lokale Veränderung des effektiven Brechungsindex in einer der beiden Wellenleiterschichten werden Teilbereiche definiert, in denen die Wellenleiter optisch gekoppelt sind. Damit die erste Wellenleiterschicht und die zweite Wellenleiterschicht optisch gekoppelt sind, werden also die Brechzahlen der ersten und der zweiten Wellenleiterschicht und die Dicke und die Brechzahl der zwischen den Wellenleiterschichten angeordneten zweiten Mantelschicht derart gewählt, dass die in der aktiven Schicht erzeugte Laserstrahlung zumindest in Teilbereichen aus der ersten Wellenleiterschicht in die zweite Wellenleiterschicht übergekoppelt wird.

Bei einer bevorzugten Ausführungsform sind die erste Wellenleiterschicht und die zweite Wellenleiterschicht in einem ersten Teilbereich und einem zweiten Teilbereich optisch gekoppelt, wobei der erste Teilbereich und der zweite Teilbereich an die Seitenfacetten des Halbleiterlasers angrenzen.

Bei dieser Ausführungsform können beispielsweise die Brechzahlen der ersten Wellenleiterschicht und der zweiten Wellenleiterschicht in einem zentralen Bereich des Halbleiterlasers voneinander abweichen, so dass in dem zentralen Bereich keine Kopplung der Wellenleiterschichten vorliegt. Dagegen sind im Bereich der Seitenfacetten des Halbleiterlasers die Brechzahlen der ersten Wellenleiterschicht und der zweiten Wellenleiterschicht derart aneinander angepasst, dass die in der aktiven Schicht, die in die erste Wellenleiterschicht eingebettet ist, erzeugte Laserstrahlung aus der ersten Wellenleiterschicht in die zweite Wellenleiterschicht überkoppeln kann. In diesem Fall wird also insbesondere durch elektrisches Pumpen der aktiven Schicht in dem zentralen Bereich des Halbleiterlasers Laserstrahlung erzeugt, die sich in lateraler Richtung zu den Seitenfacetten des Halbleiterlasers hin ausbreitet, bis sie in den an die Seitenfacetten des Halbleiterlasers angrenzenden Teilbereichen zumindest teilweise von der ersten Wellenleiterschicht in die zweite Wellenleiterschicht übergekoppelt wird.

Die Breiten des ersten Teilbereichs und des zweiten Teilbereichs sind vorzugsweise gleich der Transferlänge, wobei die Transferlänge der Abstand zwischen einem Intensitätsmaximum und einem benachbarten Intensitätsminimum innerhalb einer Wellenleiterschicht ist. Die Transferlänge ist also gleich der Strecke, in der eine maximale Überkopplung der Laserstrahlung von der ersten Wellenleiterschicht in die zweite Wellenleiterschicht erfolgt.

Auf diese Weise wird vorteilhaft erreicht, dass an der Seitenfacette des Halbleiterlasers ein Intensitätsminimum in der ersten Wellenleiterschicht, die die aktive Schicht enthält, und ein Intensitätsmaximum in der zweiten Wellenleiterschicht vorliegen.

Bei einer weiteren bevorzugten Ausführungsform sind die erste Wellenleiterschicht und die zweite Wellenleiterschicht in einem ersten Teilbereich und einem zweiten Teilbereich optisch gekoppelt, wobei der erste Teilbereich und der zweite Teilbereich jeweils in einem Abstand von einer Seitenfacette des Halbleiterlasers angeordnet sind. Wie bei der zuvor beschriebenen Ausführungsform sind die erste Wellenleiterschicht und die zweite Wellenleiterschicht in einem zentralen Bereich des Halbleiterlasers optisch nicht gekoppelt, weil sie zum Beispiel voneinander abweichende effektive Brechungsindizes aufweisen. In dem ersten und zweiten Teilbereich sind die effektiven Brechungsindizes der ersten Wellenleiterschicht und der zweiten Wellenleiterschicht dagegen aneinander angepasst, so dass in diesen Teilbereichen die in der aktiven Schicht erzeugte Laserstrahlung zumindest teilweise aus der ersten Wellenleiterschicht in die zweite Wellenleiterschicht überkoppeln kann. Der Unterschied zu der zuvor beschriebenen Ausführungsform besteht darin, dass der erste Teilbereich und der zweite Teilbereich nicht bis an die Seitenfacette des Halbleiterlasers heranreichen, sondern zwischen dem ersten Teilbereich und dem zweiten Teilbereich und den Seitenfacetten des Halbleiterlasers jeweils ein Bereich vorliegt, in dem die Wellenleiterschichten optisch nicht gekoppelt sind.

Die Breiten des ersten Teilbereichs und des zweiten Teilbereichs sind auch bei dieser Ausführungsform vorzugsweise gleich der Transferlänge, also der Weglänge, in der die Laserstrahlung maximal von der ersten Wellenleiterschicht zur zweiten Wellenleiterschicht überkoppelt. In einem zentralen Bereich des Halbleiterlasers durch elektrisches Pumpen erzeugte Laserstrahlung breitet sich in Richtung der Seitenfacetten des Halbleiterlasers aus und wird in dem ersten Teilbereich und dem zweiten Teilbereich, in denen eine optische Kopplung zwischen der ersten Wellenleiterschicht und der zweiten Wellenleiterschicht vorliegt, zumindest teilweise in die zweite Wellenleiterschicht übergekoppelt.

Außerhalb des ersten und zweiten Teilbereichs sind an die Seitenfacetten des Halbleiterlasers angrenzende Bereiche angeordnet, in denen keine optische Kopplung vorliegt. In diesen Bereichen bleibt daher die Intensität der in die zweite Wellenleiterschicht übergekoppelten Laserstrahlung in der zweiten Wellenleiterschicht konstant, so dass die Intensität der Laserstrahlung an den Seitenfacetten des Halbleiterlasers jeweils ein Intensitätsmaximum in der zweiten Wellenleiterschicht und ein Intensitätsminimum in der ersten Wellenleiterschicht aufweist.

Diese Ausführungsform hat gegenüber der zuvor beschriebenen Ausführungsform den Vorteil, dass bei der Herstellung des kantenemittierenden Halbleiterlasers die Seitenfacetten durch ein Durchtrennen des Halbleiterkörpers in einem Bereich erzeugt werden können, in dem keine optische Kopplung der beiden Wellenleiterschichten vorliegt, so dass sich möglicherweise auftretende Justagetoleranzen nicht auf die Stärke der Überkopplung der Laserstrahlung von der ersten Wellenleiterschicht in die zweite Wellenleiterschicht auswirken. Vielmehr ist es bei dieser Ausführungsform möglich, die Breiten des ersten Teilbereichs und des zweiten Teilbereichs mittels fototechnischer Verfahren exakt zu definieren, um insbesondere zu erreichen, dass die Breiten des ersten und zweiten Teilbereichs gleich der Transferlänge, in der eine maximale Überkopplung der Laserstrahlung stattfindet, sind.

Bei den zuvor beschriebenen Ausführungsformen der Erfindung erfolgt die optische Kopplung der ersten und zweiten Wellenleiterschicht vorzugsweise dadurch, dass der effektive Brechungsindex der ersten Wellenleiterschicht und der zweiten Wellenleiterschicht zumindest in Teilbereichen aneinander angepasst wird. Dies bedeutet, dass Teilbereiche der ersten oder der zweiten Wellenleiterschicht, in denen die erste Wellenleiterschicht und die zweite Wellenleiterschicht optisch gekoppelt sind, einen anderen effektiven Brechungsindex aufweisen als zumindest ein Teilbereich der ersten oder zweiten Wellenleiterschicht, in dem keine optische Kopplung vorliegt. Beispielsweise kann die zweite Wellenleiterschicht in ihrer gesamten lateralen Ausdehnung einen konstanten effektiven Brechungsindex aufweisen, während der effektive Brechungsindex in der ersten Wellenleiterschicht in den Teilbereichen, in denen eine optische Kopplung vorliegt, einen anderen Wert aufweist als in zumindest einem Teilbereich, in dem keine optische Kopplung der Wellenleiterschichten vorliegt.

Alternativ ist es auch möglich, dass die erste Wellenleiterschicht einen räumlich konstanten effektiven Brechungsindex aufweist, während die zweite Wellenleiterschicht in den Teilbereichen, in denen eine optische Kopplung der Wellenleiterschichten erfolgen soll, einen anderen effektiven Brechungsindex aufweist als in zumindest einem Teilbereich, in dem keine optische Kopplung der Wellenleiterschichten erfolgen soll.

Die räumliche Variation des effektiven Brechungsindex in zumindest einer der Wellenleiterschichten kann beispielsweise dadurch realisiert sein, dass die Teilbereiche der ersten oder der zweiten Wellenleiterschicht, in denen die erste Wellenleiterschicht und die zweite Wellenleiterschicht optisch gekoppelt sind, einen anderen Dotierstoff und/oder eine andere Dotierstoffkonzentration aufweisen als die Teilbereiche der ersten oder zweiten Wellenleiterschicht, in denen keine optische Kopplung der Wellenleiterschichten vorliegt. Alternativ ist es auch möglich, dass die Teilbereiche der ersten oder der zweiten Wellenleiterschicht, in dem die erste und die zweite Wellenleiterschicht optisch gekoppelt sind, zumindest teilweise oxidiert sind. Bei diesen Verfahren zur lokalen Variation des effektiven Brechungsindex in einer der Wellenleiterschichten erfolgt die Positionierung und Herstellung der Teilbereiche, in denen der effektive Brechungsindex verändert ist, durch an sich bekannte Verfahren, zum Beispiel durch Aufbringen einer Maskenschicht und nachfolgendes Eindiffundieren oder Implantieren eines zusätzlichen oder eines anderen Dotierstoffs oder durch einen Oxidationsprozess, beispielsweise durch eine feuchtthermische Oxidation.

Eine weitere Möglichkeit, eine optische Kopplung in Teilbereichen der ersten und zweiten Wellenleiterschicht zu erzeugen, besteht darin, dass in diesen Teilbereichen ein Steg (ridge) in der Halbleiterschichtenfolge ausgebildet wird, zum Beispiel durch einen Ätzprozess. In diesem Fall kann die Laserstrahlung teilweise in das seitlich an den Steg angrenzende Umgebungsmedium, beispielsweise eine Passierungsschicht, eindringen. Auf diese Weise ändert sich der effektive Brechungsindex in ähnlicher Weise, wie er sich dadurch verändert, dass die Laserstrahlung in vertikaler Richtung teilweise in die Mantelschichten eindringt.

Bei einer weiteren bevorzugten Ausführungsform sind die erste Wellenleiterschicht und die zweite Wellenleiterschicht in ihrer gesamten lateralen Ausdehnung optisch gekoppelt. Dazu sind vorteilhaft die Dicke und der Brechungsindex der zwischen der ersten Wellenleiterschicht und der zweiten Wellenleiterschicht angeordneten zweiten Mantelschicht sowie die effektiven Brechungsindizes der ersten Wellenleiterschicht und der zweiten Wellenleiterschicht derart aneinander angepasst, dass die in der aktiven Schicht erzeugte Laserstrahlung über die gesamte Breite des Halbleiterlasers von der ersten Wellenleiterschicht in die zweite Wellenleiterschicht und umgekehrt überkoppeln kann. Die in der aktiven Schicht erzeugte Laserstrahlung bildet in dem durch die Seitenfacetten des Halbleiterlasers gebildeten Resonator eine stehende Welle aus, die bei dieser Ausführungsform in lateraler Richtung in periodisch angeordneten Abständen jeweils Intensitätsmaxima in der ersten Wellenleiterschicht und korrespondierende Intensitätsminima in der zweiten Wellenleiterschicht sowie Intensitätsminima in der ersten Wellenleiterschicht und korrespondierende Intensitätsmaxima in der zweiten Wellenleiterschicht aufweist. In dem Halbleiterlaser gibt es also periodisch angeordnete Bereiche, in denen die sich entlang der Wellenleiterschichten ausbreitende Laserstrahlung eine hohe Intensität in der ersten Wellenleiterschicht und eine niedrige Intensität in der zweiten Wellenleiterschicht aufweist, und dazwischen angeordnete Bereiche, in denen die Laserstrahlung eine hohe Intensität in der zweiten Wellenleiterschicht und eine niedrige Intensität in der ersten Wellenleiterschicht aufweist.

Vorzugsweise weist die stehende Welle an den Seitenfacetten des Halbleiterlasers jeweils ein Intensitätsminimum in der ersten Wellenleiterschicht auf. Dies bedeutet, dass sich die Laserstrahlung im Bereich der Seitenfacette im Wesentlichen oder vorzugsweise vollständig in der zweiten Wellenleiterschicht ausbreitet, so dass die Laserstrahlung an der Seitenfacette des Halbleiterlasers in der aktiven Schicht nur eine geringe oder vorzugsweise gar keine Intensität aufweist.

Zum elektrischen Pumpen der aktiven Schicht des Halbleiterlasers sind vorzugsweise mehrere Kontaktflächen in periodischer Abfolge auf Teilbereiche des Halbleiterlasers aufgebracht. Dabei entspricht der Abstand der Kontaktflächen vorteilhaft der zweifachen Transferlänge, wobei die Transferlänge der Abstand zwischen einem Intensitätsmaximum und einem benachbarten Intensitätsminimum innerhalb einer der Wellenleiterschichten ist. Die Transferlänge gibt also den Abstand an, in dem eine maximale Überkopplung der Laserstrahlung von der ersten Wellenleiterschicht zur zweiten Wellenleiterschicht auftritt. Die zweifache Transferlänge ist demnach der Abstand zwischen zwei benachbarten Intensitätsmaxima in der ersten Wellenleiterschicht oder der zweiten Wellenleiterschicht. Dadurch, dass die Kontaktflächen den Abstand der zweifachen Transferlänge aufweisen, werden in der aktiven Schicht gezielt zwei benachbarte Intensitätsmaxima durch elektrisches Pumpen angeregt. Unter dem Abstand der Kontaktflächen wird hierbei der Abstand der Mittelpunkte der Kontaktflächen verstanden. Dabei ist es vorteilhaft, wenn Kontaktflächen, die den Seitenfacetten des Halbleiterlasers benachbart sind, in einem Abstand von der Seitenfacette des Halbleiterlasers angeordnet sind, der gleich der Transferlänge L_{c} oder einem ungeradzahligen Vielfachen der Transferlänge L_{c} ist. Dabei ist unter dem Abstand der Kontaktfläche von der Seitenfläche der Abstand des Mittelpunkts der Kontaktfläche von der Seitenfläche zu verstehen. Auf diese Weise wird erreicht, dass Teilbereiche der aktiven Schicht elektrisch gepumpt werden, die um eine Transferlänge oder um ein ungeradzahliges Vielfaches der Transferlänge von der Seitenfacette beabstandet sind. Die sich aus diesen elektrisch gepumpten Teilbereichen in Richtung der Seitenfacetten ausbreitende Laserstrahlung kann innerhalb der Transferlänge maximal und vorzugsweise nahezu vollständig in die zweite Wellenleiterschicht überkoppeln, so dass an den Seitenfacetten des Halbleiterlasers jeweils ein Intensitätsminimum in der aktiven Schicht und ein Intensitätsmaximum in der zweiten Wellenleiterschicht vorliegt.

Die Erfindung wird im Folgenden anhand von drei Ausführungsbeispielen im Zusammenhang mit den Figuren 1 bis 3 näher erläutert.

Es zeigen:
- Figur 1: eine schematische Darstellung eines Querschnitts durch ein erstes Ausführungsbeispiel eines kantenemittierenden Halbleiterlasers gemäß der Erfindung,
- Figur 2: eine schematische Darstellung eines Querschnitts durch ein zweites Ausführungsbeispiel eines kantenemittierenden Halbleiterlasers gemäß der Erfindung, und
- Figur 3: eine schematische Darstellung eines Querschnitts durch ein drittes Ausführungsbeispiel eines kantenemittierenden Halbleiterlasers gemäß der Erfindung.

Gleiche oder gleichwirkende Elemente sind in den Figuren mit den gleichen Bezugszeichen versehen. Die Figuren sind nicht als maßstabsgerecht anzusehen, vielmehr können einzelne Elemente zur Verdeutlichung übertrieben groß dargestellt sein.

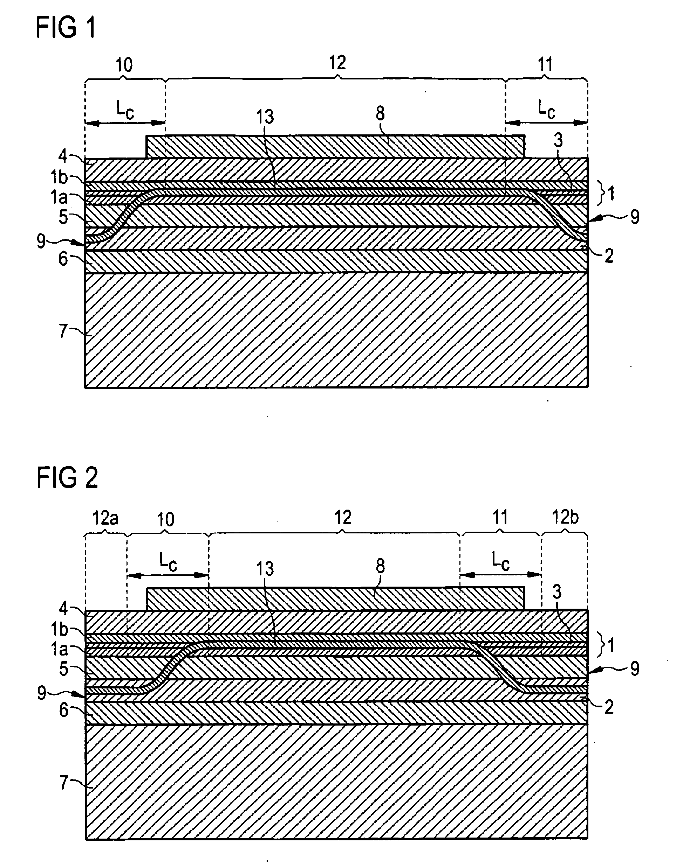

Der in Figur 1 dargestellte kantenemittierende Halbleiterlaser umfasst eine Halbleiterschichtenfolge, die eine erste Wellenleiterschicht 1 enthält, in die eine aktive Schicht 3 eingebettet ist. Die erste Wellenleiterschicht 1 ist aus einer ersten Teilschicht 1a und einer zweiten Teilschicht 1b zusammengesetzt, zwischen denen die aktive Schicht 3 angeordnet ist. Die erste Wellenleiterschicht 1 ist zwischen einer ersten Mantelschicht 4 und einer zweiten Mantelschicht 5 angeordnet. An die zweite Mantelschicht 5 grenzt eine zweite Wellenleiterschicht 2 an, in die keine aktive Schicht eingebettet ist. Weiterhin ist an einer von der ersten Wellenleiterschicht 1 abgewandten Seite der zweiten Wellenleiterschicht 2 eine dritte Mantelschicht 6 angeordnet. Die Halbleiterschichtenfolge ist beispielsweise auf ein Substrat 7 aufgewachsen.

Zur elektrischen Kontaktierung des Halbleiterlasers ist auf eine von dem Substrat 7 abgewandte Seite der Halbleiterschichtenfolge eine Kontaktfläche 8 aufgebracht, bei der es sich beispielsweise um eine Kontaktmetallisierung handeln kann. In lateraler Richtung wird die Halbleiterschichtenfolge, insbesondere die darin enthaltene erste Wellenleiterschicht mit der darin eingebetteten aktiven Schicht 3, durch Seitenfacetten 9 des Halbleiterlasers begrenzt. Die Seitenfacetten 9 des Halbleiterlasers können insbesondere mittels Durchtrennen des Halbleitermaterials erzeugt sein.

Die erste Wellenleiterschicht 1 und die zweite Wellenleiterschicht 2 sind in Teilbereichen 10, 11 optisch aneinander gekoppelt. Dies bedeutet, dass in der aktiven Schicht 3 erzeugte Laserstrahlung in den Teilbereichen 10, 11 aus der ersten Wellenleiterschicht 1 in die zweite Wellenleiterschicht 2 überkoppeln kann.

Die Stärke der optischen Kopplung, die den Anteil der Laserstrahlung 13 bestimmt, die aus der ersten Wellenleiterschicht 1 in die zweite Wellenleiterschicht 2 überkoppeln kann, hängt insbesondere von der Differenz der effektiven Brechungsindizes n₁ der ersten Wellenleiterschicht 1 und n₂ der zweiten Wellenleiterschicht 2 ab. Weiterhin hängt die Stärke der optischen Kopplung der ersten Wellenleiterschicht 1 an die zweite Wellenleiterschicht 2 von der Dicke und dem Brechungsindex der zwischen der ersten Wellenleiterschicht 1 und der zweiten Wellenleiterschicht 2 angeordneten zweiten Mantelschicht 5 ab.

Beispielsweise sind in dem zentralen Bereich 12 des Halbleiterlasers die effektiven Brechungsindizes der ersten Wellenleiterschicht 1 und der zweiten Wellenleiterschicht 2 derart voneinander verschieden, dass die in der ersten Wellenleiterschicht 1 erzeugte Laserstrahlung 13 nicht in die zweite Wellenleiterschicht 2 überkoppeln kann. In diesem Bereich des Halbleiterlasers breitet sich die Laserstrahlung 13 also nur innerhalb der ersten Wellenleiterschicht 1 aus.

In den an die Seitenfacetten 9 angrenzenden Teilbereichen 10, 11 sind die effektiven Brechungsindizes der ersten Wellenleiterschicht 1 und der zweiten Wellenleiterschicht 2 dagegen derart aneinander angepasst, dass die Laserstrahlung 13 in die zweite Wellenleiterschicht 2 überkoppeln kann. Die Wellenleiterschicht 1 weist dazu in den Teilbereichen 10, 11 einen anderen effektiven Brechungsindex auf als in dem zentralen Bereich 12.

Die Änderung des effektiven Brechungsindex der ersten Wellenleiterschicht 1 in den Teilbereichen 10, 11 kann bei der Herstellung des Halbleiterlasers dadurch erfolgen, dass nach dem Aufwachsen der ersten Wellenleiterschicht 1 in den Teilbereichen 10, 11 die Dotierstoffkonzentration erhöht oder ein weiterer Dotierstoff zugefügt wird. Dazu wird beispielsweise auf den zentralen Bereich 12 eine Maske aufgebracht und der zusätzliche Dotierstoff in die Teilbereiche 10, 11 implantiert oder eindiffundiert. Eine andere Möglichkeit zur lokalen Änderung des effektiven Brechungsindex in den Teilbereichen 10, 11 der ersten Wellenleiterschicht 1 besteht darin, dass diese Teilbereiche der ersten Wellenleiterschicht 1 bei der Herstellung des Halbleiterlasers oxidiert werden, zum Beispiel durch eine feuchtthermische Oxidation.

Bevorzugt ist die zweite Wellenleiterschicht 2 derart an die erste Wellenleiterschicht 1 optisch gekoppelt, dass die sich in der ersten Wellenleiterschicht 1 ausbreitende Laserstrahlung 13 an den Seitenfacetten 9 des Halbleiterlasers ein Intensitätsminimum aufweist. Die Breiten des ersten Teilbereichs 10 und des zweiten Teilbereichs 11 werden dazu so gewählt, dass sie gleich der Transferlänge L_{c} sind, wobei die Transferlänge L_{c} die Strecke ist, in der eine maximale Überkopplung der Laserstrahlung 13 von der ersten Wellenleiterschicht 1 zur zweiten Wellenleiterschicht 2 auftritt. Wenn die Breiten des ersten Teilbereichs 10 und des zweiten Teilbereichs 11 geringer als die Transferlänge L_{c} sind, wird nur ein geringerer Teil als der maximal mögliche Teil der Laserstrahlung 13 aus der ersten Wellenleiterschicht 1 in die zweite Wellenleiterschicht 2 übergekoppelt. Wenn die Breiten der Teilbereiche 10, 11 größer sind als die Transferlänge L_{c}, würde die Laserstrahlung 13 ausgehend von dem zentralen Bereich 12 bei ihrer Ausbreitung in Richtung der Seitenfacetten 9 zunächst maximal von der ersten Wellenleiterschicht 1 zur zweiten Wellenleiterschicht 2 überkoppeln und in dem Bereich der Strecke, die über die Transferlänge L_{c} hinausgeht, wieder teilweise in die erste Wellenleiterschicht 1 überkoppeln. Die erwünschte Minimierung der Intensität der Laserstrahlung 13 im Bereich der aktiven Schicht 3 an der Seitenfacette 9 tritt also genau dann ein, wenn die Breiten der Teilbereiche 10, 11 gleich der Transferlänge L_{c} sind.

Die Breite der Teilbereiche 10, 11 kann beispielsweise dadurch an die Transferlänge L_{c} angepasst werden, dass zunächst Teilbereiche 10, 11 mit verändertem effektiven Brechungsindex in der ersten Wellenleiterschicht erzeugt werden, die eine größere Breite als die Transferlänge L_{c} aufweisen, und anschließend die Laserfacetten 9 durch Durchtrennen des Halbleitermaterials in einer Richtung senkrecht zu den Schichtebenen derart erzeugt werden, dass die Breiten der Teilbereiche 10, 11 der Transferlänge L_{c} entsprechen.

Die Kontaktfläche 8, beispielsweise eine Kontaktmetallisierung, ist vorzugsweise auf einen Teilbereich der Oberfläche des Halbleiterlasers aufgebracht, der im Wesentlichen mit der Breite des zentralen Bereichs 12 übereinstimmt, in dem die erste Wellenleiterschicht 1 und die zweite Wellenleiterschicht 2 optisch nicht aneinander gekoppelt sind. Auf diese Weise wird die Laseremission in der aktiven Schicht 3 vorteilhaft in dem Teilbereich 12 des Halbleiterlasers durch elektrisches Pumpen angeregt, in dem eine maximale Intensität in der Wellenleiterschicht 1 erwünscht ist. In den Teilbereichen 10, 11, in denen die Laserstrahlung 13 in die zweite Wellenleiterschicht 2 überkoppelt, wird in der ersten Wellenleiterschicht 1 vorzugsweise keine Laseremission durch elektrisches Pumpen angeregt.

Das in Figur 2 dargestellte Ausführungsbeispiel der Erfindung entspricht im Wesentlichen dem ersten Ausführungsbeispiel, wobei es sich aber dadurch von dem ersten Ausführungsbeispiel unterscheidet, dass die Teilbereiche 10, 11 der ersten Wellenleiterschicht 1, in denen die erste Wellenleiterschicht 1 und die zweite Wellenleiterschicht 2 optisch aneinander gekoppelt sind, nicht unmittelbar an die Seitenfacetten 9 des Halbleiterlasers angrenzen, sondern in einem Abstand von einer Seitenfacette 9 des Halbleiterlasers angeordnet sind.

Der Halbleiterlaser weist also einen zentralen Bereich 12 auf, in dem keine optische Kopplung der ersten Wellenleiterschicht 1 und der zweiten Wellenleiterschicht 2 vorliegt. Nach außen, das heißt in Richtung der Seitenfacetten, grenzen an den zentralen Bereich 12 Teilbereiche 10, 11 an, in denen eine optische Kopplung der ersten Wellenleiterschicht 1 und der zweiten Wellenleiterschicht 2 vorliegt. Weiter nach außen grenzen an die Teilbereiche 10, 11 Teilbereiche 12a, 12b an, in denen wiederum keine optische Kopplung der ersten Wellenleiterschicht 1 an die zweite Wellenleiterschicht 2 vorliegt. Die Teilbereiche 12a, 12b erstrecken sich bis zu den Seitenfacetten 9 des Halbleiterlasers.

Wie bei dem ersten Ausführungsbeispiel sind die Breiten der Teilbereiche 10, 11 vorteilhaft gleich der Transferlänge L_{c}, so dass die in der aktiven Schicht 3 erzeugte Laserstrahlung 13 in den Teilbereichen 10, 11 maximal aus der ersten Wellenleiterschicht 1 in die zweite Wellenleiterschicht 2 überkoppeln kann. In den sich nach außen anschließenden Teilbereichen 12a, 12b, in denen keine optische Kopplung der ersten Wellenleiterschicht 1 und der zweiten Wellenleiterschicht 2 vorliegt, wird die Laserstrahlung in der zweiten Wellenleiterschicht 2 geführt, ohne in die erste Wellenleiterschicht zurückzukoppeln. Auf diese Weise wird vorteilhaft erreicht, dass an den Seitenfacetten 9 des Halbleiterlasers im Bereich der aktiven Schicht 3 ein Intensitätsminimum der Laserstrahlung vorliegt, während sie im Bereich der zweiten Wellenleiterschicht an der Seitenfacette 9 des Halbleiterlasers eine maximale Intensität aufweist. Die Herstellung der Teilbereiche 10, 11, in denen der effektive Brechungsindex der ersten Wellenleiterschicht 1 an den effektiven Brechungsindex der zweiten Wellenleiterschicht 2 angepasst ist, kann wie bei dem ersten Ausführungsbeispiel beispielsweise durch eine lokale Veränderung der Dotierung-oder durch eine-Oxidation der Teilbereiche 10, 11 erfolgen.

Im Gegensatz zum ersten Ausführungsbeispiel können vorteilhaft sowohl die innere Begrenzung als auch die äußere Begrenzung der Teilbereiche 10, 11 vergleichsweise genau durch fototechnische Verfahren, insbesondere durch Aufbringen einer Maskenschicht auf die seitlich angrenzenden Bereiche 12, 12a 12b des Halbleiterkörpers, definiert werden. Möglicherweise auftretende Toleranzen bei der Positionierung der Trennschnitte zur Erzeugung der Seitenfacetten 9 des Halbleiterlasers wirken sich im Gegensatz zum ersten Ausführungsbeispiel nicht auf die Breite der Teilbereiche 10, 11 aus, in denen die optische Kopplung der ersten Wellenleiterschicht 1 an die zweite Wellenleiterschicht 2 erfolgt. Dies hat den Vorteil, dass die Breiten der Teilbereiche 10, 11 vergleichsweise genau an die Transferlänge L_{c} angepasst werden können.

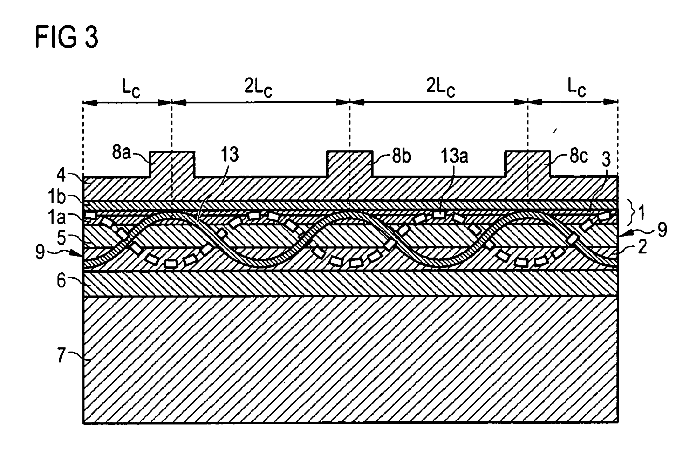

Das in Figur 3 dargestellte dritte Ausführungsbeispiel der Erfindung unterscheidet sich von den zuvor beschriebenen Ausführungsbeispielen dadurch, dass die erste Wellenleiterschicht 1 und die zweite Wellenleiterschicht 2 in ihrer gesamten lateralen Ausdehnung optisch aneinander gekoppelt sind. In diesem Fall sind also die effektiven Brechungsindizes der ersten Wellenleiterschicht 1 und der zweiten Wellenleiterschicht 2 derart aneinander angepasst, dass in der gesamten Breite des Halbleiterlasers die in der aktiven Schicht 3 erzeugte Laserstrahlung 13 aus der ersten Wellenleiterschicht 1 in die zweite Wellenleiterschicht 2 und umgekehrt überkoppeln kann.

Die Laserstrahlung 13 bildet in dem durch die Laserfacetten 9 gebildeten-Resonator eine stehende Welle aus, so dass in der ersten Wellenleiterschicht 1 und der zweiten Wellenleiterschicht 2 jeweils periodisch angeordnete Intensitätsminima und Intensitätsmaxima auftreten. In den Wellenleiterschichten 1, 2 sind die Intensitätsmaxima und Intensitätsminima jeweils um die Transferlänge L_{c} voneinander beabstandet. An den Stellen, an denen die Laserstrahlung 13 in der ersten Wellenleiterschicht 1 ein Intensitätsmaximum aufweist, weist sie in der zweiten Wellenleiterschicht 2 ein korrespondierendes Intensitätsminimum auf und umgekehrt.

Bevorzugt weist die Laserstrahlung 13 an den Seitenfacetten 9 des Halbleiterlasers jeweils ein Intensitätsminimum in der ersten Wellenleiterschicht 1 auf, die die aktive Schicht 3 enthält. An der Seitenfacette 9 des Halbleiterlasers ist also die Intensität der Laserstrahlung 13 in der ersten Wellenleiterschicht 1 minimal und in der zweiten Wellenleiterschicht 2 maximal.

Zum elektrischen Pumpen der aktiven Schicht 3 sind auf eine dem Substrat 7 gegenüber liegende Oberfläche der Halbleiterschichtenfolge des Halbleiterlasers mehrere Kontaktflächen 8a, 8b, 8c aufgebracht, durch die ein elektrischer Strom in Teilbereiche der aktiven Schicht 3 eingeprägt werden kann. Als zweiter elektrischer Kontakt kann beispielsweise das Substrat 7 fungieren, das in diesem Fall elektrisch leitend ist.

Die Mittelpunkte der den Seitenfacetten 9 des Halbleiterlasers benachbarten Kontaktflächen 8a, 8c sind vorzugsweise jeweils um eine Transferlänge L_{c} von der jeweiligen Seitenfacette 9 beabstandet. Auf diese Weise wird erreicht, dass durch elektrisches Pumpen der aktiven Schicht 3 ein Intensitätsmaximum in der ersten Wellenleiterschicht 1 in einem Abstand von der Seitenfacette 9 des Halbleiterlasers erzeugt wird, der gleich der Transferlänge L_{c} ist. Die in diesen Bereichen erzeugte Laserstrahlung kann bei der Ausbreitung in Richtung der Seitenfacetten 9 maximal in die zweite Wellenleiterschicht 2 überkoppeln, so dass an der Seitenfacette 9 ein Intensitätsmaximum in der zweiten Wellenleiterschicht 2 und ein korrespondierendes Intensitätsminimum in der ersten Wellenleiterschicht 1 vorliegt. Diese Anordnung der Kontaktflächen 8a, 8b, 8c hat weiterhin zur Folge, dass die als gestrichelte Linie dargestellte stehende Welle 13a, welche Intensitätsmaxima in der ersten Wellenleiterschicht 1 im Bereich der Seitenfacetten 9 aufweisen würde, nicht durch elektrisches Pumpen angeregt wird. Die Mittelpunkte der Kontaktflächen 8a, 8b, 8c sind untereinander jeweils um die zweifache Transferlänge L_{c} beabstandet, um die benachbarten Intensitätsmaxima innerhalb der ersten Wellenleiterschicht anzuregen.

Die in Figur 3 dargestellte Ausführungsform der Erfindung hat insbesondere den Vorteil, dass eine lokale Veränderung des effektiven Brechungsindex in einer der Wellenleiterschichten nicht erforderlich ist.

## Patentansprüche

1. Kantenemittierender Halbleiterlaser mit einer Laserstrahlung (13) erzeugenden aktiven Schicht (3), die in eine erste Wellenleiterschicht (1) eingebettet ist, wobei die erste Wellenleiterschicht (1) zwischen einer ersten Mantelschicht (4) und einer zweiten Mantelschicht (5) angeordnet ist und in lateraler Richtung an Seitenfacetten (9) des Halbleiterlasers angrenzt, wobei
- an die zweite Mantelschicht (5) eine zweite Wellenleiterschicht (2) angrenzt, in die keine aktive Schicht eingebettet ist,
- die zweite Wellenleiterschicht (2) zumindest in Teilbereichen (10, 11) optisch an die erste Wellenleiterschicht (1) gekoppelt ist, und
- an einer von der ersten Wellenleiterschicht (1) abgewandten Seite der zweiten Wellenleiterschicht (2) eine dritte Mantelschicht (6) angeordnet ist **dadurch gekennzeichnet, dass**
die Teilbereiche (10, 11) der ersten Wellenleiterschicht (1) oder der zweiten Wellenleiterschicht (2), in denen die erste Wellenleiterschicht (1) und die zweite Wellenleiterschicht (2) optisch gekoppelt sind, einen anderen Dotierstoff und/oder eine andere Dotierstoffkonzentration aufweisen als zumindest ein Teilbereich (12) der ersten Wellenleiterschicht (1) oder zweiten Wellenleiterschicht (2), in dem keine optische Kopplung vorliegt, oder zumindest teilweise oxidiert
sind, so dass die Teilbereiche (10, 11) der ersten Wellenleiterschicht (1) oder der zweiten Wellenleiterschicht (2), in denen die erste Wellenleiterschicht (1) und die zweite Wellenleiterschicht (2) optisch gekoppelt sind, einen anderen effektiven Brechungsindex aufweisen als zumindest ein Teilbereich (12) der ersten Wellenleiterschicht (1) oder zweiten Wellenleiterschicht (2), in dem keine optische Kopplung vorliegt.

2. Kantenemittierender Halbleiterlaser nach Anspruch 1, wobei
die zweite Wellenleiterschicht (2) derart an die erste Wellenleiterschicht (1) optisch gekoppelt ist, dass sich an den Seitenfacetten (9) des Halbleiterlasers zumindest ein Teil der in der aktiven Schicht (3) erzeugten Laserstrahlung (13) in der zweiten Wellenleiterschicht (2) ausbreitet.

3. Kantenemittierender, Halbleiterlaser nach Anspruch 2, wobei
die zweite Wellenleiterschicht (2) derart an die erste Wellenleiterschicht (1) optisch gekoppelt ist, dass die sich die in der ersten Wellenleiterschicht (1) ausbreitende Laserstrahlung an den Seitenfacetten (9) des Halbleiterlasers ein Intensitätsminimum aufweist.

4. Kantenemittierender Halbleiterlaser nach einem der Ansprüche 1 bis 3, wobei
die erste Wellenleiterschicht (1) und die zweite Wellenleiterschicht (2) in einem ersten Teilbereich (10) und einem zweiten Teilbereich (11) optisch gekoppelt sind, wobei der erste Teilbereich (10) und der zweite Teilbereich (11) an die Seitenfacetten (9) des Halbleiterlasers angrenzen.

5. Kantenemittierender Halbleiterlaser nach einem der Ansprüche 1 bis 3, wobei
die erste Wellenleiterschicht (1) und die zweite Wellenleiterschicht (2) in einem ersten Teilbereich (10) und einem zweiten Teilbereich (11) optisch gekoppelt sind, wobei der erste Teilbereich (10) und der zweite Teilbereich (11) jeweils in einem Abstand von einer Seitenfacette (9) des Halbleiterlasers angeordnet sind.

6. Kantenemittierender Halbleiterlaser nach Anspruch 4 oder 5, wobei
die Breiten des ersten Teilbereichs (10) und des zweiten Teilbereichs (11) gleich der Transferlänge (L_{c}) sind, wobei die Transferlänge (L_{c}) der Abstand zwischen einem Intensitätsmaximum und einem benachbarten Intensitätsminimum innerhalb einer der Wellenleiterschichten (1, 2) ist.

## Claims

1. Edge emitting semiconductor laser comprising an active layer (3) that generates laser radiation (13) and is embedded into a first waveguide layer (1), wherein the first waveguide layer (1) is arranged between a first cladding layer (4) and a second cladding layer (5) and adjoins side facets (9) of the semiconductor laser in a lateral direction,
wherein
- a second waveguide layer (2), into which no active layer is embedded, adjoins the second cladding layer (5),
- the second waveguide layer (2) is optically coupled to the first waveguide layer (1) at least in partial regions (10, 11), and
- a third cladding layer (6) is arranged at a side of the second waveguide layer (2) that is remote from the first waveguide layer (1),
**characterized in that**
the partial regions (10, 11) of the first waveguide layer (1) or of the second waveguide layer (2) in which the first waveguide layer (1) and the second waveguide layer (2) are optically coupled have a different dopant and/or a different dopant concentration than at least one partial region (12) of the first waveguide layer (1) or second waveguide layer (2) in which no optical coupling is present, or are at least partly oxidized, so that the partial regions (10, 11) of the first waveguide layer (1) or of the second waveguide layer (2) in which the first waveguide layer (1) and the second waveguide layer (2) are optically coupled have a different effective refractive index than at least one partial region (12) of the first waveguide layer (1) or second waveguide layer (2) in which no optical coupling is present.

2. Edge emitting semiconductor laser according to Claim 1,
wherein
the second waveguide layer (2) is optically coupled to the first waveguide layer (1) in such a way that, at the side facets (9) of the semiconductor laser, at least part of the laser radiation (13) generated in the active layer (3) propagates in the second waveguide layer (2).

3. Edge emitting semiconductor laser according to Claim 2,
wherein
the second waveguide layer (2) is optically coupled to the first waveguide layer (1) in such a way that the laser radiation propagating in the first waveguide layer (1) has an intensity minimum at the side facets (9) of the semiconductor laser.

4. Edge emitting semiconductor laser according to any of Claims 1 to 3,
wherein
the first waveguide layer (1) and the second waveguide layer (2) are optically coupled in a first partial region (10) and a second partial region (11), wherein the first partial region (10) and the second partial region (11) adjoin the side facets (9) of the semiconductor laser.

5. Edge emitting semiconductor laser according to any of Claims 1 to 3,
wherein
the first waveguide layer (1) and the second waveguide layer (2) are optically coupled in a first partial region (10) and a second partial region (11), wherein the first partial region (10) and the second partial region (11) are in each case arranged at a distance from a side facet (9) of the semiconductor laser.

6. Edge emitting semiconductor laser according to Claim 4 or 5,
wherein
the widths of the first partial region (10) and of the second partial region (11) are equal to the transfer length (L_{c}), wherein the transfer length (L_{c}) is the distance between an intensity maximum and an adjacent intensity minimum within one of the waveguide layers (1, 2).

## Revendications

1. Laser semi-conducteur à émission par les bords, comprenant une couche active (3) générant un rayonnement laser (13) qui est enrobée dans une première couche guide d'onde (1), la première couche guide d'onde (1) étant disposée entre une première couche d'enveloppe (4) et une deuxième couche d'enveloppe (5) et étant contiguë à des facettes latérales (9) du laser semi-conducteur dans le sens latéral, dans lequel
- une deuxième couche guide d'onde (2), dans laquelle n'est enrobée aucune couche active, est contiguë à la deuxième couche d'enveloppe (5),
- la deuxième couche guide d'onde (2) est couplée optiquement avec la première couche guide d'onde (1) au moins dans des zones partielles (10, 11) et
- une troisième couche d'enveloppe (6) est disposée sur un côté de la deuxième couche guide d'onde (2) à l'opposé de la première couche guide d'onde (1)
**caractérisé en ce que**
les zones partielles (10, 11) de la première couche guide d'onde (1) ou de la deuxième couche guide d'onde (2), dans lesquelles la première couche guide d'onde (1) et la deuxième couche guide d'onde (2) sont couplées optiquement, présentent une matière de dopage différente et/ou une concentration de matière de dopage différente d'au moins une zone partielle (12) de la première couche guide d'onde (1) ou de la deuxième couche guide d'onde (2) dans laquelle il n'existe pas de couplage optique, ou alors elles sont au moins partiellement oxydées, de sorte que les zones partielles (10, 11) de la première couche guide d'onde (1) ou de la deuxième couche guide d'onde (2), dans lesquelles la première couche guide d'onde (1) et la deuxième couche guide d'onde (2) sont couplées optiquement, présentent un indice de réfraction efficace différent d'au moins une zone partielle (12) de la première couche guide d'onde (1) ou de la deuxième couche guide d'onde (2) dans laquelle il n'existe pas de couplage optique.

2. Laser semi-conducteur à émission par les bords selon la revendication 1, dans lequel la deuxième couche guide d'onde (2) est couplée optiquement avec la première couche guide d'onde (1) de telle sorte qu'au niveau des facettes latérales (9) du laser semi-conducteur, au moins une partie du rayonnement laser (13) généré dans la couche active (3) se propage dans la deuxième couche guide d'onde (2).

3. Laser semi-conducteur à émission par les bords selon la revendication 2, dans lequel la deuxième couche guide d'onde (2) est couplée optiquement avec la première couche guide d'onde (1) de telle sorte que le rayonnement laser qui se propage dans la première couche guide d'onde (1) présente un minimum d'intensité au niveau des facettes latérales (9) du laser semi-conducteur.

4. Laser semi-conducteur à émission par les bords selon l'une des revendications 1 à 3, dans lequel la première couche guide d'onde (1) et la deuxième couche guide d'onde (2) sont couplées optiquement dans une première zone partielle (10) et une deuxième zone partielle (11), la première zone partielle (10) et la deuxième zone partielle (11) étant contiguës à des facettes latérales (9) du laser semi-conducteur.

5. Laser semi-conducteur à émission par les bords selon l'une des revendications 1 à 3, dans lequel la première couche guide d'onde (1) et la deuxième couche guide d'onde (2) sont couplées optiquement dans une première zone partielle (10) et une deuxième zone partielle (11), la première zone partielle (10) et la deuxième zone partielle (11) étant respectivement disposées à une certaine distance d'une facette latérale (9) du laser semi-conducteur.

6. Laser semi-conducteur à émission par les bords selon la revendication 4 ou 5, dans lequel les largeurs de la première zone partielle (10) et de la deuxième zone partielle (11) sont égales à la longueur de transfert (L_{c}) la longueur de transfert (L_{c}) étant l'écart entre un maximum d'intensité et un minimum d'intensité voisin à l'intérieur de l'une des couches guides d'onde (1, 2).
